# EUROPEAN PATENT APPLICATION

(11) **EP 1 286 580 A2**
(43) Date of publication of application: **26.02.2003**
(21) Application number: 02017667.3
(22) Date of filing: 06.08.2002
(51) Int. Cl.: H05K 7/10

(54) **Integrated circuit socket with floating alignment member**

(30) Priority: 07.08.2001 US 923748
(71) Applicant: JOHNSTECH INTERNATIONAL CORPORATION, Minneapolis, Minnesota 55413 (US)
(72) Inventor: Van Hove, Chad L., Eagan, MN 55123 (US); Maccoux, Danial A., Brooklyn Park, MN 55443 (US); Warwick, Brian K., Ben Lomond, CA 95005 (US)
(74) Representative: Kirschner, Klaus Dieter, Dipl.-Phys.

(57) **Abstract**

The present invention is a floating alignment member for use with integrated circuits. The member has a body generally comprised of an alignment plate. The alignment plate has a contact surface, an interface surface, and a plurality of apertures formed through the plate. Each of the plurality of apertures has an interior wall that forms the aperture and at least a portion of the interior wall is conically tapered inward from the interface surface to the contact surface. Each aperture is oriented on the plate to accommodate a contact of an integrated circuit.

## Description

### Background of the Invention

The present invention is generally related to the field of integrated circuit testing. In particular, the present invention relates to an integrated circuit socket device having a floating alignment member.

Integrated chip technology is continually in pursuit of the production of devices that have larger numbers of contacts confined to smaller areas. These devices are also being integrated into greater numbers of end products and provide a wider array of possible functions to the devices in which they are placed. Due to the increasing importance of integrated circuits, it is increasingly important that the circuits are accurately and thoroughly tested, and that the circuits are not damaged during manufacturing processes, the testing process, or application of the circuit to a product. It is also important that the contacts of the integrated circuit be reliably connected to the contacts of the device into which the circuit is placed.

Since there are a large number of connections that need to be made to an integrated circuit, it has become a common practice in the art to use a socket having a plurality of fixed contacts that may be connected to the contacts of the integrated circuit. Sockets have significantly improved the reliability of the connections to integrated circuits, however, problems do still exist.

Typically, the contacts of an integrated circuit are oriented in a grid array format, such as a, ball grid array (BGA) or pin grid array (PGA). These array systems provide a large number of small contacts that are oriented in a grid pattern. Today, the grid array systems are being formed so small that both the contacts of the integrated circuit and the socket contacts are prone to damage due to bending or breakage of the contacts. Additionally, the contacts can become deformed through their interface with each other and, therefore, the contacts may not form a connection or, alternatively, the connection may not be reliable.

Although these problems can occur in all areas where sockets are utilized, such as test sockets, burn-in sockets, device-under-test sockets, production sockets, and the like, both deformation and breakage that cause reliability and connection problems are particularly applicable to the areas of test sockets and burn-in sockets. This is due to the fact that many integrated circuits are placed into a socket and removed during the testing and burn-in processes and, therefore, through continued insertion and removal of circuits into a socket the socket may become damaged, thereby damaging the integrated circuits that are placed within it or producing erroneous test results indicating that the integrated circuit is faulty.

Damage and unreliable connections typically occur due to the rigidity of the connection between the socket and the integrated circuit and due to whether the integrated circuit is properly aligned with respect to the contacts of the socket. The rigidity of the contacts of the devices create problems because the contacts must be placed in contact with each other in order to create a connection between them. If the connection of the contacts is made too forcefully, the contacts may become bent or broken. Additionally, if the two sets of contacts are misaligned when they are placed together, some of the members may become broken or bent during the seating of the circuit in the socket and the misalignment and bent condition of some contacts may result in an unreliable or nonexistent connection.

Accordingly, an alignment member and socket should be developed that can allow placement of an integrated circuit therein, without damage to the circuit and/or socket. Additionally, an alignment member and socket should be developed that are capable of providing a reliable connection between the integrated circuit and the contacts of the socket. The present invention addresses these needs, as well as other problems associated with existing alignment members and sockets.

### Summary of The Invention

The present invention is a floating alignment member for use with integrated circuits. The member is has a body generally comprised of an alignment plate. The alignment plate has a contact surface, an interface surface, and a plurality of apertures formed through the plate. Each of the plurality of apertures has an interior wall that forms the aperture and at least a portion of the interior wall is conically tapered inward from the interface surface to the contact surface. Each aperture is oriented on the plate to accommodate a contact of an integrated circuit.

According to one embodiment of the present invention, the body of the alignment member may also be comprised of a plurality of side portions. The side portions and the alignment plate define an interior cavity with the alignment plate at its bottom. Each of the side portions have an interior side that forms a wall of the cavity. One or more of the interior sides may also have a portion that is tapered inward toward the center of the cavity as the interior side approaches the alignment plate.

The apertures may be sized to allow at least a portion of a contact of an integrated circuit to be positioned below the contact surface. The apertures are preferably sized to allow a contact of an integrated circuit to pass substantially through the aperture. For example, the apertures may be sized and arranged to each accommodate a ball of a ball grid array integrated circuit to pass substantially through the aperture.

In another embodiment of the invention, an integrated circuit socket is comprised of a socket body, an alignment member, a structure for resiliently spacing the alignment member from the surfaces that define the socket cavity, and a structure for providing the fine alignment of the integrated circuit as it is placed on the alignment member.

The socket body defines an interior socket cavity that has a contact surface at its bottom with a plurality of contacts positioned thereon. The contacts may be resiliently attached to the contact surface. The socket may also be comprised of structure for rough alignment of an integrated circuit as the circuit is placed on the alignment member. In this embodiment the alignment member may be further comprised of a body comprising a plurality of side portions and a alignment plate. The side portions and alignment plate define an interior cavity. Each of the side portions have an interior side that forms a wall of the cavity. One or more of the interior sides has a portion that is tapered inward toward the center of the cavity as the interior side approaches the alignment plate. This structure may be provided for the rough alignment of an integrated circuit. A contribution to the rough alignment of the integrated circuit may also be provided by the structure for resiliently spacing the alignment member from the surfaces defining the socket cavity.

The structure for resiliently spacing the alignment plate from the surfaces defining said socket cavity may be comprised of one or more resilient members. The resilient members may be a plurality of springs oriented between the alignment plate and the socket body.

The alignment member is constructed and arranged to be movable in the vertical direction within the confines of said socket cavity. The alignment member may also be constructed and arranged to move in the horizontal direction within the confines of the socket cavity. The alignment member may be comprised of a substantially planar plate.

The alignment member may also be comprised of an interface surface with a plurality of apertures formed therethrough. Each aperture has an interior sidewall and at least one of the apertures has a sidewall in which at least a portion of the sidewall is tapered conically inward toward the center of the aperture which provides the structure for fine alignment of an integrated circuit. A contribution to the fine alignment of the integrated circuit may also be provided by the structure for resiliently spacing the alignment member from the surfaces defining the socket cavity.

In another embodiment, the integrated circuit socket is comprised of a socket body, an alignment member, and at least one resilient member attached between the socket body and the alignment member. The socket body defines an interior socket cavity having a contact surface at its bottom with a plurality of contacts positioned thereon. The alignment member is constructed and arranged to be movable within the confines of the socket cavity. The alignment member is comprised of a plurality of side walls and an alignment plate. The walls and plate are arranged to define an alignment cavity. The alignment plate has a plurality of apertures therethrough with each aperture being constructed and arranged to accommodate a ball of a ball grid array integrated circuit.

The resilient member or members are attached between said socket body and the alignment plate for resiliently spacing the alignment plate from the surfaces defining the socket cavity.

The apertures may be sized to allow at least a portion of the ball of a ball grid array integrated circuit to be positioned below the contact surface. Additionally, the apertures of the alignment plate may be sized and arranged to each allow a ball of a ball grid array integrated circuit to pass substantially through the aperture. The apertures may have an interior wall forming the aperture with at least a portion of the interior wall being conically tapered inward from the interface surface to the contact surface with each aperture oriented on the plate to accommodate a contact of an integrated circuit.

The aforementioned benefits and other benefits of the invention will become clear from the following description by reference to the accompanying drawings.

### Brief Description of The Drawings

**FIG. 1** is a detailed cutaway view of a socket of one embodiment of the present invention in its unconnected condition;
**FIG. 2** is a detailed cutaway view of a socket of the present invention in its connected condition;
**FIG. 3** is a perspective view showing the unassembled parts of an embodiment of the present invention; and
**FIG. 4** is a detailed side cutaway view of a socket of the present invention.

### Detailed Description of the Invention

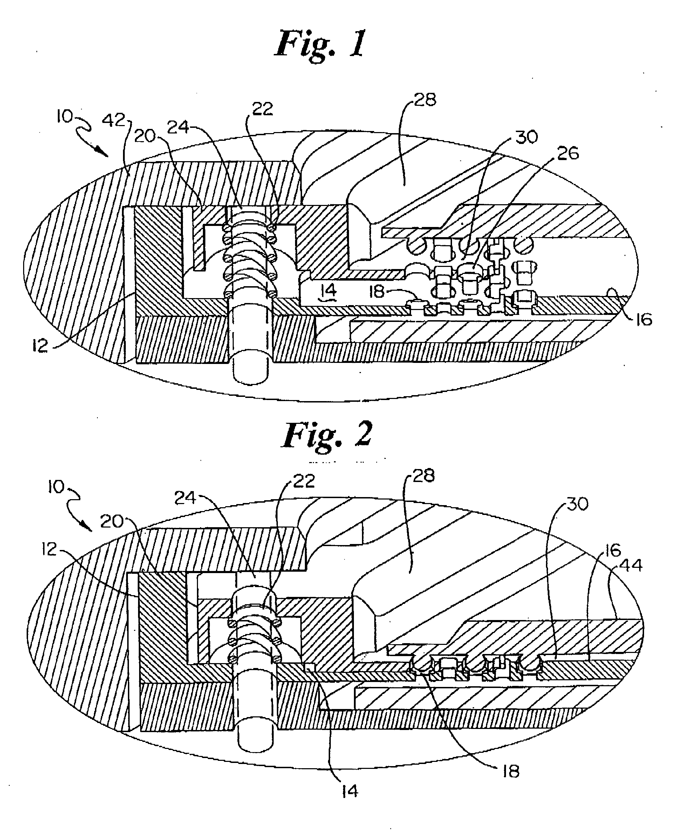

Referring now to the drawings wherein like reference numerals denote like elements throughout the several views, **FIG. 1** illustrates a socket having an alignment member of the present invention and shows the invention having an integrated circuit placed in the socket prior to a connection being formed between the contacts of the integrated circuit and the socket. FIG. 2 illustrates the socket and integrated circuit in a connected condition. As shown, the socket 10 is generally comprised of a socket body 12, and an alignment member 20. The socket body 12 defines an interior socket cavity 14 with a contact surface 16 having a plurality of contacts 18 at its bottom. This socket cavity would traditionally form the socket into which an integrated circuit is placed. However, as shown in FIG. 1, this device 10 incorporates an alignment member 20 into the socket to assure more consistent alignment of the integrated circuit 44 prior to and during its placement into contact with the contacts 18 of the socket. Therefore, the socket, as shown, is sized to accommodate the alignment member 20.

The alignment member 20 is generally comprised of an alignment plate 36 that has a contact surface 38 and an interface surface 30. The interface surface 30 is the surface that interfaces with the surface of the integrated circuit 44 that has the contacts mounted thereon. The contact surface 38 is the surface that is positioned nearest to the contacts 18 of the socket.

A plurality of apertures 40 are provided through the alignment plate 36. The apertures 40 are positioned such that they substantially correspond to the positioning of the contacts 18 upon the contact surface 16. Each of the apertures 40 is also formed by an interior side wall 26. The interior wall 26 of each aperture 40 is preferably tapered toward the center of the aperture defined by the wall. The tapering allows the contacts of the integrated circuit to find the apertures 40 even when it is slightly misaligned, because the tapering of the apertures, guides the contacts into the proper, aligned position within the apertures. This structure provides a means for the fine alignment of the integrated circuit 44 with respect to the contacts 18 of the socket body 12.

It is preferred that the interior walls 26 be tapered at an angle that is conducive to urging the contacts of the integrated circuit 44 into the apertures 40. Any suitable angle may be utilized for this function. For example, one such suitable angle is 30 degrees from a line normal to the contact surface 38. The walls are preferably conically tapered to facilitate smooth movement of the contact of the integrate circuit into position. Furthermore, the spacing between the centers of the apertures corresponds to the distance between the center of the contacts of the integrated circuit, however, it is conceivable that the spaces between the apertures may be tapered toward the nearest aperture to facilitate the movement of contacts that are substantially misaligned.

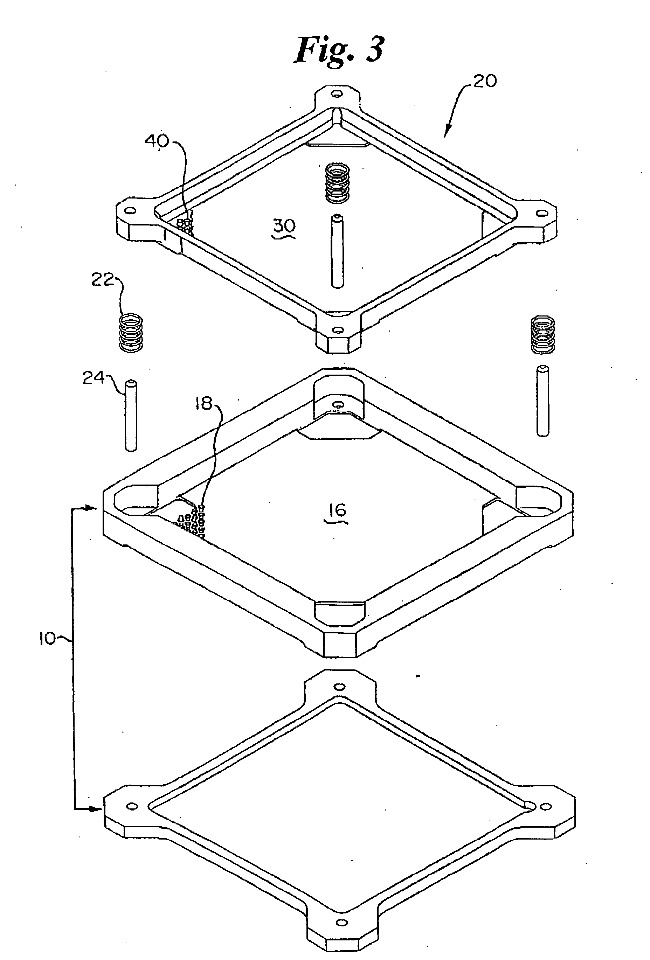

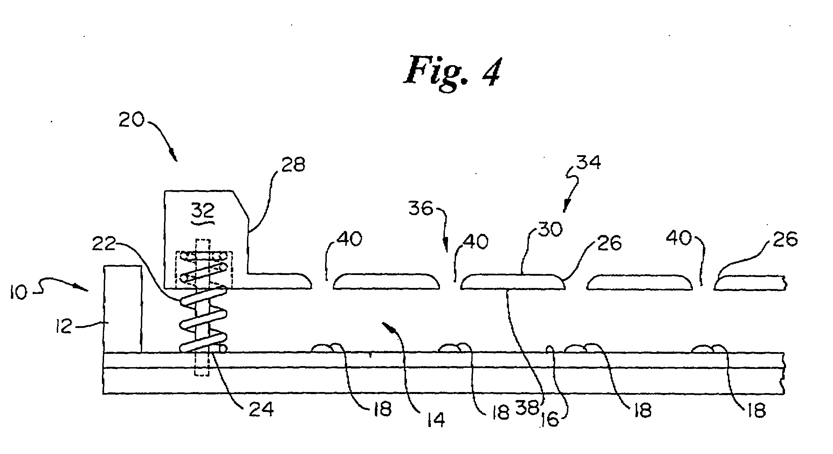

When the alignment member 20 is positioned into a socket, the alignment member is resiliently spaced from the surfaces defining the socket cavity 14. The alignment member 20 may be resiliently suspended within the socket cavity 14 by any means known in the art. The preferred means is provided by one or more resilient members provided between the socket body 12 and the alignment member 20. For example, as shown in FIGS. 1-4, the means may be comprised of a spring mounted in each corner of the socket 10 and arranged between the socket body 12 and the alignment plate 20. This resilient means provides several functions. For example, the resilient means provides a cushioning action for connection between the two sets of contacts. This function provides some protection of the contacts from the potentially violent contact when the two sets of contacts are connected. The resilient means also provides a slight force against the integrated circuit, thereby urging the contacts of the integrated circuit into position within the apertures 40. In this way, the means for resiliently positioning the alignment member contributes to the fine alignment of the integrated circuit.

The spaced orientation, provided by the means for resiliently spacing the alignment member with respect to the contact surface 16, allows the alignment member 20 to move with respect to the socket body 12. The alignment member 20 may move in both the horizontal and vertical directions within the confines of the socket cavity 14, if the alignment member 20 and socket cavity 14 are sized to allow for such movement. The device may also be configured for movement in only the vertical direction with respect to the contact surface 16. As shown, a guide pin 24, placed within each spring 22, may also be utilized to control the movement of the alignment member 20. These arrangements provide different means for allowing the rough alignment of the integrated circuit with respect to the alignment member 20 and provide the vertical movement of the alignment member 20 which allows the two sets of contacts to connect.

Rough alignment may also be provided by means of a structure that directs a misaligned circuit into a generally aligned position. One such structure is shown in FIGS. **1**, **2**, and **4**. In this embodiment, the alignment member 20 is comprised of an alignment member body 32 that is formed around the alignment plate 36. The body 32 and plate 36 form an alignment cavity 34 with the alignment plate 36 at its bottom. The alignment cavity 34 has a plurality of interior side portions 28 formed by the interior sides of the body member 32. At least a portion of these side portions 28 may be angled inward toward the alignment plate 36, thereby providing a means for roughly aligning the circuit 44 with the contacts of the socket body 12.

Since many possible embodiments may be made of the present invention without departing from the scope thereof, it is to be understood that all matter herein set forth or shown in the accompanying drawings is to be interpreted in the illustrative and not limiting sense.

## Claims

1. A floating alignment member for use with integrated circuits, comprising:
a body comprised of an alignment plate having a contact surface, an interface surface, and a plurality of apertures formed through said plate, each of said plurality of apertures having an interior wall forming the aperture and at least a portion of said interior wall being conically tapered inward from the interface surface to the contact surface, each said aperture being oriented on said plate to accommodate a contact of an integrated circuit.

2. The member according to claim 1, wherein said body is further comprised of a plurality of side portions, said side portions and said alignment plate defining an interior cavity.

3. The member according to claim 2, wherein each of said side portions has an interior side forming a wall of the cavity and wherein at least one of said interior sides has a portion that is tapered inward toward the center of the cavity as the interior side approaches the alignment plate.

4. The member according to claim 1, wherein said aperture is sized to allow a contact of an integrated circuit to pass substantially through the aperture.

5. The member according to claim 1, wherein said apertures are sized and arranged to each accommodate a ball of a ball grid array integrated circuit to pass substantially through the aperture.

6. The member according to claim 1, wherein said apertures are sized to allow at least a portion of a contact of an integrated circuit to be positioned below the contact surface.

7. An integrated circuit socket, comprising:
a socket body defining an interior socket cavity having a contact surface at its bottom with a plurality of contacts positioned thereon;
an alignment member constructed and arranged to be movable within the confines of said socket cavity;
means for resiliently spacing said alignment plate from the surfaces defining said socket cavity; and
means for fine alignment of an integrated circuit as it is placed on said alignment plate.

8. The socket according to claim 7, wherein said means for resiliently spacing is provided by at least one resilient member.

9. The socket according to claim 7, wherein said means for resiliently spacing is provided by a plurality of spring members oriented between said socket body and said alignment member.

10. The socket according to claim 7, wherein said alignment member is movable in the vertical direction with respect to said contact surface.

11. The socket according to claim 7, is further comprised of means for rough alignment of an integrated circuit as it is placed on said alignment member.

12. The socket according to claim 11, wherein said alignment member is further comprised of a body comprised of a plurality of side portions and an alignment plate, said side portions and alignment plate defining an interior cavity, each of said side portions having an interior side forming a wall of the cavity and wherein at least one of said interior sides has a portion that is tapered inward toward the center of the cavity as the interior side approaches the alignment plate, said tapered side portions providing the means for rough alignment of an integrated circuit.

13. The socket according to claim 7, wherein said alignment member comprises an interface surface with a plurality of apertures formed therethrough, each said aperture having an interior sidewall and at least one of said apertures having a sidewall wherein at least a portion is tapered conically inward toward the center of said aperture for providing the means for fine alignment of an integrated circuit.

14. The socket according to claim 7, wherein said means for resiliently spacing also contributes to said rough and fine alignment of an integrated circuit.

15. The socket according to claim 10, wherein said alignment member is also movable in the horizontal direction within the confines of the socket cavity.

16. The socket according to claim 7, wherein said contacts are resiliently positioned on said contact surface.

17. An integrated circuit socket, comprising:
a socket body defining an interior socket cavity having a contact surface at its bottom with a plurality of contacts positioned thereon;
an alignment member constructed and arranged to be movable in the vertical direction within the confines of said socket cavity, said alignment member comprised of a plurality of side walls and a alignment plate, said walls and plate arranged to define an alignment cavity, said alignment plate having a plurality of apertures therethrough, each aperture being constructed and arranged to accommodate a ball of a ball grid array integrated circuit; and
at least one resilient member attached between said socket body and said alignment plate for resiliently spacing said alignment plate from the surfaces defining said socket cavity.

18. The socket according to claim 17, wherein said apertures are sized and arranged to each allow a ball of said ball grid array integrated circuit to pass substantially through the aperture.

19. The member according to claim 17, wherein said apertures are sized to allow at least a portion of the ball of said ball grid array integrated circuit to be positioned below the contact surface.

20. The socket according to claim 17, wherein each of said apertures has an interior wall forming the aperture and a plurality of said apertures having at least a portion of said interior wall being conically tapered inward from the interface surface to the contact surface, each said aperture being oriented on said plate to accommodate a contact of an integrated circuit.
